# EUROPEAN PATENT APPLICATION

(11) **EP 0 583 640 A1**
(43) Date of publication of application: **23.02.1994**
(21) Application number: 93111676.8
(22) Date of filing: 21.07.1993
(51) Int. Cl.: H01F 5/08, G01R 33/035

(54) **Magnetic pickup coil**

(30) Priority: 23.07.1992 JP 216595/92
(71) Applicant: SUPERCONDUCTING SENSOR LABORATORY, Inba-gun, Chiba-ken (JP)
(72) Inventor: Tsukada, Keiji, Inba-gun, Chiba-ken (JP)
(74) Representative: Finsterwald, Manfred, Dipl.-Ing., Dipl.-Wirtsch.-Ing.

(57) **Abstract**

A magnetic pickup coil (1A, 1B) comprises a structural member made of an electrical insulating material (2), linear grooves (6) formed in the structural member by an optical method such as laser beam irradiation and a thin layer of niobium or other superconducting material (7) formed in the grooves.

## Description

This invention relates to a magnetic pickup coil for a high-sensitivity magnetic sensor suitable for use, for example, in magnetoencephalography, magnetocardiography, measurement of the magnetic field of the musculi oculi and other types of magnetic biometry, measurement of geomagnetism and measurement of the degree of magnetisation of materials, and more particularly to such a magnetic pickup coil using a superconductor.

One method conventionally used for fabricating a magnetic pickup coil using a superconductor has been to mechanically machine grooves into the peripheral surface of a cylindrical insulator formed of fiber reinforced plastic (FRP) or the like and to hand-wind superconductor wire (e.g. a niobium-titanium (Nb-Ti) superconductor wire) into the grooves.

In addition, H.E. Hoeing et al. recently proposed a method for fabricating a magnetic pickup coil which employs a photo-fabrication technique (a photoresist or photoetching method using photoengraving techniques) for forming a superconductor coil pattern in a thin flexible substrate and then attaching the flexible substrate formed with the coil to a support member (IEEE Transaction on Magnetics vol. 27, No. 2, pp2777 - 2784).

Since the former of the two fabrication methods mentioned above relies on handwork in the production process, it is not able to provide finished coils with uniform sensitivity and other characteristics. What is more, as this method requires the use of a coil wire with a diameter of at least several hundreds of micrometers, it is inherently limited as regards size reduction.

In the latter method, the use of an optical method for forming the coil pattern enables use of coil wire measuring only several micrometers in diameter and makes it possible to obtain coils of consistent configuration. On the other hand, since the final magnetic pickup coil is obtained by attaching the flexible substrate formed with the coil to the surface of a cylindrical support body, variation in coil characteristics is liable to arise between different coils in the attached state. This becomes a problem when, for example, two or more coils are used to obtain a differential, as in the case of a differential coil.

The present invention was accomplished to overcome the aforesaid problems and has as its object to provide a magnetic pickup coil that can be fabricated with high reproducibility as regards the uniformity of its completed configuration and coil characteristics.

According to this invention, there is provided a magnetic pickup coil comprising an electric insulator substrate optically formed on its surface with linear grooves and a thin layer of superconducting material formed in the grooves.

In the present invention, since the formation of the grooves in the insulator substrate is conducted optically, as by scanning with a laser beam, the coil can be fabricated according to the designed configuration, making it possible to obtain much more uniform products than is possible with conventional hand fabrication. In the case of using a method which employs laser beam irradiation for progressively producing the coil and wiring patterns according to the designed configuration, the shape of the grooves is governed by the precision of the laser beam. Since this precision is extremely high, magnetic pickup coils that have finer pattern features and are smaller in size than conventional magnetic pickup coils can be obtained with ease.

Moreover, since the invention enables the superconducting material constituting the coil and wiring portions to be formed using advanced semiconductor production technologies such as vacuum deposition and sputtering, it is able to provide products that are uniform in both configuration and sensitivity and to do so with high reproducibility.

The above and other features of the present invention will become apparent from the following description made with reference to the drawings, in which:
Figure 1 is a perspective view of an embodiment of the magnetic pickup coil according to the present invention.
Figure 2 is an enlarged sectional view of a coil groove in the magnetic pickup coil of Figure 1.
Figure 3 is a block diagram of a magnetic field measurement system using the magnetic pickup coil of Figure 1.
Figure 4 is a perspective view of another embodiment of the magnetic pickup coil according to the present invention.

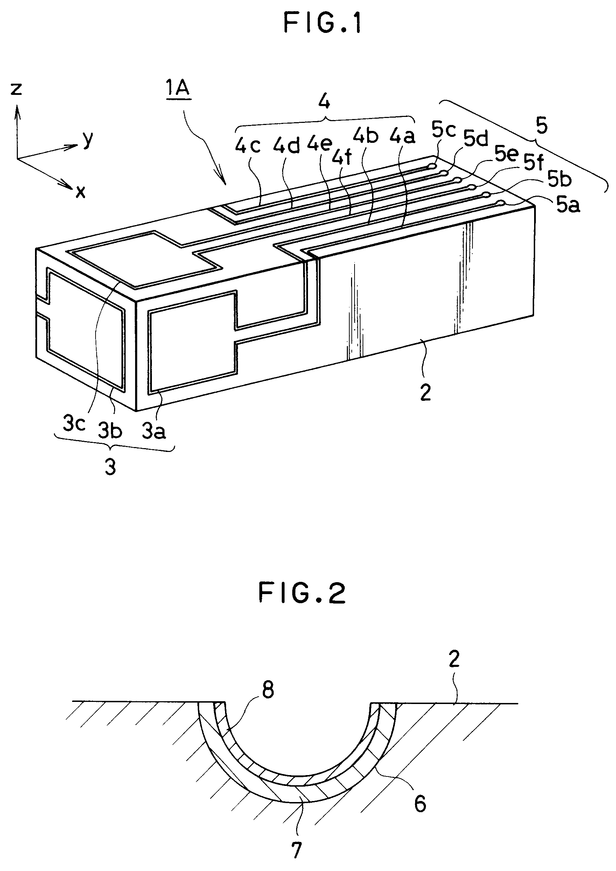

The magnetic pickup coil according to the present invention will now be explained with reference to the illustrated embodiments. Figure 1 is a perspective view showing the configuration of a magnetic pickup coil 1A which is a first embodiment of the invention. The magnetic pickup coil 1A is designed to be capable of simultaneously measuring all components of a three-dimensional magnetic field.

As shown in Figure 1, the magnetic pickup coil 1A comprises a structural insulator member 2 formed of glass or other insulating material and constituting a substrate, a superconducting coil portion 3 formed on the surface of the structural insulator member 2 for, in its superconducting state, detecting a magnetic field and producing shielding currents, a superconducting wiring portion 4 for conducting the shielding currents, and a terminal portion 5 for outputting the shielding currents to a SQUID.

As also shown in Figure 1, the superconducting coil portion 3 consists of an x-direction coil 3a, a y-direction coil 3b and a z-direction coil 3c arranged to enable measurement of magnetic field components in three mutually perpendicular directions designated x, y and z. The superconducting wiring portion 4 consists of wires 4a, 4b connected with the x-direction coil 3a, wires 4c, 4d connected with the y-direction coil 3b, and wires 4e, 4f connected with the z-direction coil 3c. The terminal portion 5 consists of terminals 5a, 5b connected with the wires 4a, 4b, terminals 5c, 5d connected with the wires 4c, 4d, and terminals 5e, 5f connected with the wires 4e, 4f. Connection can made with these terminals from the exterior of the magnetic pickup coil 1A.

The composition of the superconducting coil portion 3, the superconducting wiring portion 4 and the terminal portion 5 and the process by which these portions are formed will be explained with reference to Figure 2.

The fabrication of the magnetic pickup coil 1A is started by passing the laser beam from an excimer laser over the surface of the structural insulator member 2 in a pattern according to a prescribed design. As a result, the irradiated portions of the insulator undergo high-temperature fusion and vaporization, thus producing linear grooves 6 measuring about 20 µm in width and depth. Although use of an excimer laser is advantageous in view of is ability to produce a high-power laser beam that can be focused to a spot measuring several tens of µm in diameter, it is alternatively possible to use any other type of laser capable of providing similar performance.

After coil grooves for the superconducting coil portion 3, wiring grooves for the superconducting wiring portion 4 and terminal depressions for the terminal portion 5 have been formed in the foregoing manner, a layer of niobium or other superconducting material 7 is formed to a prescribed thickness, usually to a thickness of about 0.3 µm, in the coil and wiring grooves, by a vacuum thin-film forming method such as vacuum deposition or sputtering. The layers in the coil grooves and the wiring grooves can be formed of the same or different superconducting materials. The thickness of the superconducting material layers can be selected within the range of about 10 nm to about 100 µm according to necessity.

A thin layer of gold (Au) or other normal conducting material 8 exhibiting high electrical conductivity is then formed to a prescribed thickness, ordinarily to a thickness of about 500 Angstrom, on the so-formed thin layer of superconducting material 7, by a vacuum thin-film forming method such as vacuum deposition or sputtering. If different superconducting materials are used in the coil and wiring grooves, the thin film of normal conducting material can be formed only at the boundary between the superconducting coil portion and the superconducting wiring portion and at the boundary between the superconducting wiring portion and the terminal portion so as to straddle and provide electrical connection across these boundaries. On the other hand, if the same superconducting material is used in the coil and wiring grooves, the thin film of normal conducting material can be formed to cover the whole of the superconducting material. The thickness of the normal conducting material layers can be selected within the range of about 100 to about 3000 Angstroms according to necessity.

Two methods are available for ensuring that the superconducting material 7 remains only in the grooves 6.

In the first method, the substrate exhibiting electrical insulating property is coated beforehand with an organic film consisting of photoresist or the like. Grooves are then optically formed in both the photoresist and the substrate or only in the photoresist, whereafter a layer of superconducting material is applied to cover both the photoresist and the grooves. The substrate is thereafter immersed in a photoresist release agent or other solvent capable of dissolving the organic film to remove the superconducting material adhering to the organic film together with the organic film and leave only the superconducting material in the grooves. In this method, after the grooves have been optically formed, they can be made deeper or be smoothed by reactive ion etching or chemical etching.

In the second method, linear grooves are optically formed in the substrate exhibiting electrical insulating property, a layer of superconducting material is formed on the substrate, and the surface of the substrate is abraded to remove the superconducting material from all portions except the grooves.

When a magnetic pickup coil is fabricated in the foregoing manner, the precision of the coil and wiring patterns depends mainly on the laser scanning precision. Since currently available technologies enable this scanning to be conducted with extremely high precision, nonuniformity in magnetic pickup coil fabrication precision is greatly reduced in comparison with that in the case of fabrication by hand. Since it is further possible to use advanced vacuum thin-film formation technologies for forming the superconducting material layers that constitute the wires of the coil portion and the wiring portion, the thickness of these layers can be controlled precisely to the values specified by the design. As a result, it is possible to obtain magnetic pickup coils with highly uniform magnetic detection sensitivity and other coil characteristics.

When the magnetic pickup coil 1A is used to measure a magnetic field it is immersed in liquid helium so as to put it in a superconducting state and at this time it is necessary to establish superconducting electrical connection between its different portions. In magnetic pickup coils it has up to now generally been difficult to establish superconducting electrical connection between the superconducting material used in the superconducting coil and the material used in the wiring. When the method of fabrication described above is used, however, the desired electrical connection can be easily achieved thanks to the provision of the layer of gold (Au) or other normal conducting material exhibiting high electrical conductivity as a connecting layer between the superconducting coil portion and the superconducting wiring portion. Moreover, since the normal conducting material is provided as a thin film, it assumes a superconducting state owing to the proximity effect. A superconductive connection can thus be obtained even with a normal conducting material.

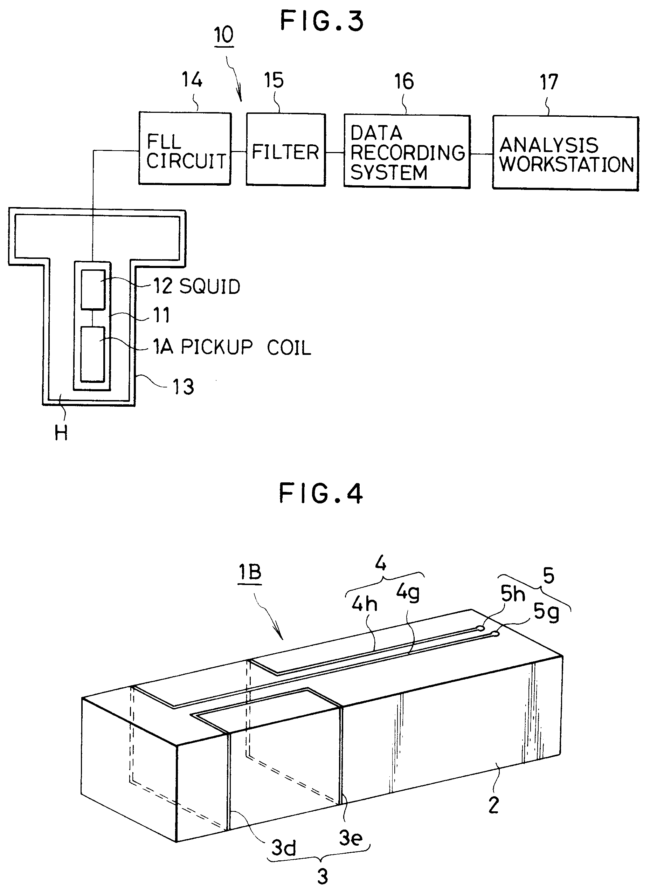

Figure 3 is a block diagram of a magnetic field measurement system 10 using the magnetic pickup coil 1A described in the foregoing. As shown in Figure 3, the magnetic field measurement system 10 comprises a SQUID probe device 11 which, being constituted of the three-dimensional magnetic pickup coil 1A for outputting shielding currents and a SQUID (superconducting quantum interference device) 12 for detecting magnetic flux fluctuation from the flux transformer, is immersed in liquid helium H contained in a Dewar vessel 13, an FLL (flux-locked loop) circuit 14 for processing the data signals from the SQUID 12, a low-noise amplifier filter 15 for removing noise components from the processed data signals, a data recording system 16 for gathering the noise-free signals for the x, y and z coordinates, and an analysis workstation 17 for analyzing the overall magnetic field from the x, y and z magnetic field components and displaying the results in various forms. When the frequency of the signals being measured is low, the FLL circuit 14 performs such functions as to increase the sensitivity with respect to the magnetic field, linearize the relationship between the output voltage and the magnetic field (output linearization) and expand the linear output range (dynamic range expansion). It is constituted as a combination of a phase detection circuit and a feedback circuit.

A second embodiment of the invention will now be explained with reference to the drawings. Figure 4 is a perspective view of a first-order derivative type magnetic pickup coil 1B which is a second embodiment of the present invention.

As shown in Figure 4, the magnetic pickup coil 1B comprises a structural insulator member 2 formed of glass or other insulating material and constituting a substrate, a superconducting coil portion 3 formed on the surface of the structural insulator member 2 for, in its superconducting state, detecting a magnetic field and producing an induced current, a superconducting wiring portion 4 for conducting the shielding current, and a terminal portion 5 for outputting the shielding current to the exterior.

As also shown in Figure 4, the superconducting coil portion 3 consists of two pickup coils 3d, 3e for measuring the magnetic field in the longitudinal direction of the structural insulator member 2. The two pickup coils 3d, 3e are formed such that the currents electromagnetically shielded therein flow in opposite directions. The superconducting wiring portion 4 comprises a wire 4g connected with the pickup coil 3d and a wire 4h connected with the reversely oriented pickup coil 3e. The terminal portion 5 has a terminal 5g connected with the wire 4g and a terminal 5h connected with the wire 4h. Connection can made with these terminals from the exterior of the magnetic pickup coil 1A. The composition of the superconducting coil portion 3, the superconducting wiring portion 4 and the terminal portion 5 and the process by which these portions are formed are the same as described with respect to the first embodiment.

In the so-constituted second embodiment of the invention, magnetic field components arriving from a magnetic field source more distant than the magnetic field to be measured and constituting noise with respect to the magnetic field to be measured can be canceled out by taking the differential between the outputs of the two pickup coils 3d, 3e. As a result, it is possible to measure the magnetic field with high accuracy.

The present invention is in no way restricted to the illustrated embodiments. All other arrangements whose technical concept is substantially identical with that set out in the claims and which manifest an effect similar to that of the present invention fall within the technical scope of the present invention.

For instance, while the foregoing embodiments were explained with respect to the case where the sectional configuration of the grooves formed by laser beam irradiation is approximately semicircular, it is alternatively possible to form the grooves to have square or triangular sectional configuration.

Instead of using a structural insulator member with the shape of a rectangular parallelepiped as in the foregoing embodiments, it is possible to use one with the shape of a polygonal prism or a cylinder. In addition, the surfaces on which the coil patterns are formed can be arbitrarily selected.

Instead of the superconducting material used for the coil portion in the embodiments set out in the foregoing, there can be used an oxide or other type superconductor.

As explained in the foregoing, in the present invention a magnetic pickup coil is fabricated by optically forming linear grooves on the surface of an electric insulator substrate and forming a thin layer of superconducting material in the grooves. Methods available for optically forming the linear grooves include that of scanning the insulator substrate with a laser beam for progressively producing the coil and wiring patterns according to the designed configuration. When this method is used, the pattern can be produced precisely according to the design and product nonuniformity can be reduced in comparison with that in the case of fabrication by hand. In the case of using the method employing laser beam irradiation for progressively producing the coil and wiring patterns according to the designed configuration, the shapes of the coils and wiring and the width of their wires is governed by the precision of the laser beam. Since this precision is extremely high, it is possible to obtain magnetic pickup coils that have pattern features that are finer than those produced using conventional mechanical machining and having features only on the order of several tens of micrometers and also possible to obtain magnetic pickup coils that are smaller in size than the conventional magnetic pickup coils.

Moreover, as regards the thickness etc. of the superconducting material constituting the coil and wiring portions, since the invention enables these portions to be formed using advanced semiconductor production technologies such as vacuum deposition and sputtering, it is able to provide products that are uniform in both configuration and sensitivity.

Further, since a thin film of a normal conducting material exhibiting high electrical conductivity is formed between the coil portion and the wiring portion and between the wiring portion and the terminals, these portions can be readily electrically connected. In addition, since the normal conducting material is provided as a thin film, it assumes a superconducting state owing to the proximity effect, making it easily possible to obtain a superconductive connection even with a normal conducting material.

## Claims

1. A magnetic pickup coil (1A, 1B) comprising an electric insulator substrate (2) optically formed on its surface with linear grooves (6) and a thin layer of superconducting material (7) formed in the grooves.

2. A magnetic pickup coil according to claim 1, further comprising a thin-film of a normal conducting material (8) exhibiting high electrical conductivity formed on the thin layer of superconducting material (7).

3. A magnetic pickup coil according to claim 1, further comprising terminals (5) at the opposite ends of the thin layer of superconducting material, the terminals being formed of a normal conducting material exhibiting high electrical conductivity and enabling electrically superconductive connection between the magnetic pickup coil and an external device.

4. A magnetic pickup coil according to claim 1, wherein the thin layer of superconducting material (7) is comprised of a first superconducting material (3, 3a, 3b, 3c, 3d, 3e) arranged in coil configuration and a second superconducting material (4, 4a, 4b, 4c, 4d, 4e, 4f, 4g, 4h) arranged in the form of a pair of wires connected at their one ends with the opposite ends of the first superconducting material, the magnetic pickup coil further comprising a pair of terminals (5, 5a, 5b, 5c, 5d, 5e, 5f, 5g, 5h) provided at the other ends of the second superconducting material, thin-films of a first normal conducting material superconductively connecting the first superconducting material and the second superconducting material and thin-films of a second normal conducting material superconductively connecting the second superconducting material and the terminals.

5. A magnetic pickup coil according to claim 1, wherein the linear grooves (6) are formed by irradiating the substrate with a laser beam.

6. A magnetic pickup coil according to claim 1, wherein the thin layer of superconducting material (7) is formed in the grooves (6) using a thin-film forming method.
